Europäisches Patentamt

European Patent Office

Office européen des brevets

(11) Veröffentlichungsnummer: **0 351 628**

**A2**

# (12) EUROPÄISCHE PATENTANMELDUNG

(21) Anmeldenummer: 89112152.7

(51) Int. Cl.⁴: **G03F 7/033**

(22) Anmeldetag: 04.07.89

(30) Priorität: 16.07.88 DE 3824146

(43) Veröffentlichungstag der Anmeldung:
24.01.90 Patentblatt 90/04

(84) Benannte Vertragsstaaten:
CH DE FR GB IT LI NL

(71) Anmelder: HOECHST AKTIENGESELLSCHAFT
Postfach 80 03 20
D-6230 Frankfurt am Main 80(DE)

(72) Erfinder: Gersdorf, Joachim, Dr. Dipl.-Chem.
Lohmühlweg 17
D-6200 Wiesbaden(DE)
Erfinder: Kroggel, Matthias, Dr. Dipl.-Chem.
Am Flachsland 15
D-6233 Kelkheim(DE)
Erfinder: Rauterkus, Karl-Josef, Dr.
Dipl.-Chem.
Im Hain 2
D-6233 Kelkheim(DE)

(54) **Lichthärtbares elastomeres Gemisch und daraus erhaltenes Aufzeichnungsmaterial für die Herstellung von Reliefdruckplatten.**

(57) Es wird ein lichthärtbares elastomeres Gemisch beschrieben, das eine radikalisch polymerisierbare Verbindung mit mindestens einer endständigen ethylenisch ungesättigten Gruppe, einen Photopolymerisationsinitiator und als Bindemittel ein in Wasser oder einer wäßrigen Lösung lösliches oder dispergierbares Pfropfpolymerisat enthält, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen und/oder deren Verseifungsprodukten und/oder von weiteren ethylenisch ungesättigten Monomeren und/oder deren Verseifungsprodukten aufgepfropft sind.

Das Gemisch ist zur Herstellung von Reliefdruckplatten, insbesondere Flexodruckplatten, geeignet und läßt sich mit Wasser oder wäßrigen Lösungen entwickeln.

## Lichthärtbares elastomeres Gemisch und daraus erhaltenes Aufzeichnungsmaterial für die Herstellung von Reliefdruckplatten

Die Erfindung betrifft ein lichthärtbares, negativ arbeitendes Gemisch und ein daraus erhaltenes Aufzeichnungsmaterial, das für die Herstellung von elastischen Reliefdruckplatten geeignet ist.

Gemische der genannten Gattung sind bekannt und enthalten gewöhnlich ein elastomeres Bindemittel, eine radikalisch polymerisierbare Verbindung und einen durch aktinische Strahlung aktivierbaren Polymerisationsinitiator. Derartige Gemische, die z. B. in der DE-C 22 15 090 beschrieben sind, lassen sich nach der Belichtung nur mit organischen Lösemitteln zum Reliefbild entwickeln.

Ein wäßrig entwickelbares System wird in der JP-A 246 047·87 auf der Basis von teilverseiftem Polyvinylacetat beschrieben, das als Pfropfgrundlage ein Polyetherpolyurethan mit Mercaptogruppen enthält. Da die Kettenübertragungskonstanten in mercaptogruppenhaltigen Systemen mit Vinylacetat sehr hoch sind, erfolgt eine Pfropfung in solchen Systemen gezielt an den Mercaptogruppen.

In der US-A 4 042 386 und den DE-B 1 902 639, 1 917 917 und 2 402 808 werden zwar wäßrig entwickelbare lichtempfindliche Aufzeichnungsmaterialien auf der Basis von teilverseiftem Polyvinylacetat zur Herstellung von Reliefdruckplatten beschrieben, jedoch wird zur Homogenisierung und Schichtausformung ein Zusatz von Wasser benötigt, der einen anschließenden Trocknungsprozeß notwendig macht. Weiterhin weisen diese Reliefdruckformen nicht die für den Flexodruck notwendige hohe Elastizität bzw. niedrige Shore-A-Härte auf.

In der DE-A 35 41 162 und der EP-B 0 080 664 werden innerlich weichgemachte teilverseifte Polyvinylacetate als Bindemittel für lichtempfindliche Aufzeichnungsmaterialien beschrieben. Diese durch Polymerisation von Vinylestern in Gegenwart von Polyalkylenoxiden und anschließende Teilverseifung erhaltenen Pfropfpolymerisate sind zwar elastischer als reine teilverseifte Polyvinylacetate, bei der Verarbeitung der entsprechenden Photopolymergemische zu flächenförmigen Aufzeichnungsmaterialien ist aber ebenfalls Wasserzusatz notwendig.

Aufgabe der Erfindung war es, in Wasser oder wäßrigen Lösungen entwickelbare lichtempfindliche elastomere Gemische vorzuschlagen, die ohne Wasserzusatz durch thermoplastische Verarbeitung zu lichtempfindlichen Reliefdruckplatten verformt werden können.

Gegenstand der Erfindung ist ein lichthärtbares elastomeres Gemisch, das als wesentliche Bestandteile

a) ein elastomeres Bindemittel,

b) eine radikalisch polymerisierbare, mit dem Bindemittel verträgliche Verbindung mit mindestens einer endständigen ethylenisch ungesättigten Gruppe und einem Siedepunkt bei Normaldruck oberhalb 100 °C und

c) eine Verbindung oder eine Verbindungskombination enthält, die unter Einwirkung von aktinischem Licht die Polymerisation der Verbindung (b) einzuleiten vermag.

Das erfindungsgemäße Gemisch ist dadurch gekennzeichnet, daß das Bindemittel ein in Wasser oder einer wäßrigen Lösung lösliches oder dispergierbares Pfropfpolymerisat ist, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen und/oder deren Verseifungsprodukten und/oder von weiteren ethylenisch ungesättigten Monomeren und/oder deren Verseifungsprodukten aufgepfropft sind.

Der Mengenanteil der aufgepfropften Komponenten beträgt im allgemeinen 10 bis 99, vorzugsweise 30 bis 90 und insbesondere 40 bis 80 Gew.-%, bezogen auf das gesamte Pfropfpolymerisat.

Die Pfropfgrundlagen bestehen aus Polyurethanen mit mindestens zwei Urethangruppen im Molekül, wobei die Anzahl der Urethangruppen pro Molekül nach oben keiner besonderen Begrenzung unterliegt und im allgemeinen höhere Werte als 2 hat.

Die als Pfropfgrundlage eingesetzten Polyurethane lassen sich nach üblichen Verfahren der Polyurethansynthese aus Diolen und Diisocyanaten herstellen und werden bevorzugt unter Verwendung von Katalysatoren, z. B. von tertiären Aminen oder organischen Zinnverbindungen, bei Temperaturen zwischen 60 und 120 °C, vorzugsweise zwischen 70 und 100 °C, synthetisiert.

Prinzipiell sind alle bei der Polyurethansynthese üblicherweise verwendeten Diole einsetzbar. Bevorzugt werden cycloaliphatische Diole, wie Cyclohexandiole, sowie aliphatische Diole mit vorzugsweise 2 bis 12 C-Atomen. Bevorzugt werden ferner Polyetherdiole, z. B. Polypropylenoxide, Polybutylenoxide, Mischpolymere aus Ethylenoxid, Propylenoxid, Butylenoxid, vorzugsweise deren Blockcopolymere; besonders bevorzugt werden Polyethylenoxide. Vorzugsweise werden Polyetherdiole, insbesondere Polyethylenglykole, mit Molekulargewichten zwischen 200 und 10 000 verwendet, wobei Polyethylenglykole mit Molekulargewichten zwischen 400 und 1500 besonders bevorzugt sind. Die Polyetherdiole werden gegebenenfalls in Kombination mit niedermolekularen aliphatischen Diolen, z. B. 1,4-Butandiol, 1,3-Propandiol, Ethylenglykol oder Diethylenglykol, eingesetzt. Bevorzugt liegt ein molares Verhältnis von Polyetherdiol zu niedermolekularem aliphatischem Diol von 1 : 0,1 bis 1 : 0,7 vor.

Als Diisocyanatkomponenten können aromatische Diisocyanate, z. B. m- und p-Xylylendiisocyanat, Tolylen-2,4-diisocyanat, Tolylen-2,6-diisocyanat oder Gemische der beiden letzteren Isomeren, Naphthylen-1,5-diisocyanat, Diphenylmethan-4,4'-diisocyanat, Phenylbenzylether-4,4'-diisocyanat und dgl. eingesetzt werden.

Bevorzugt werden aliphatische und/oder cycloaliphatische Diisocyanate. Bevorzugte aliphatische Diisocyanate sind z. B. solche mit 2 bis 12 C-Atomen im aliphatischen Rest, z. B. Ethylendiisocyanat, Propylendiisocyanat, Tetramethylendiisocyanat, 2,2,4-Trimethylhexamethylendiisocyanat.

Bevorzugte cycloaliphatische Diisocyanate sind z. B. 1,4-Diisocyanato-cyclohexan, Dicyclohexylmethan-4,4'-diisocyanat und Isophorondiisocyanat. Besonders bevorzugt werden Hexamethylendiisocyanat und Isophorondiisocyanat.

Das Molverhältnis von Diol- zu Diisocyanatkomponente liegt vorzugsweise zwischen 1 : 0,99 und 1 : 0,5, insbesondere zwischen 1 : 0,98 und 1 : 0,7. Die mittleren Molekulargewichte der Polyurethane liegen vorzugsweise zwischen 200 und 100 000, insbesondere zwischen 1 300 und 50 000, besonders bevorzugt zwischen 3 000 und 25 000.

Zum Pfropfen auf das Polyurethan werden Carbonsäurevinylester mit 3 bis 20, vorzugsweise 4 bis 14 C-Atomen eingesetzt. Besonders bevorzugt werden Vinylacetat und/oder Vinylpropionat, insbesondere Vinylacetat. Bevorzugt werden ferner Gemische aus Vinylacetat und/oder Vinylpropionat und Vinylversatat. Insbesondere bei Teil- oder Vollverseifung der Produkte im Anschluß an die Pfropfpolymerisation ist beim Pfropfen die Mitverwendung von Vinylpropionat neben Vinylacetat vorteilhaft. Außerdem lassen sich copolymerisierbare Gemische aus Carbonsäurevinylestern pfropfen, vorzugsweise Gemische aus Vinylacetat und Vinylversatat, wobei der Vinylversatatanteil 0,2 bis 10 Gew.-%, vorzugsweise 0,5 bis 5 Gew.-%, bezogen auf den Vinylacetatanteil, beträgt. Auch das Pfropfen mit verschiedenen Carbonsäurevinylestern in Form von Blockcopolymeren, gegebenenfalls in Kombination mit weiteren ethylenisch ungesättigten und copolymerisationsfähigen Monomeren, kann vorteilhaft sein. Weiterhin können die Carbonsäurevinylester auch zusammen mit anderen ethylenisch ungesättigten und copolymerisierbaren Monomeren, wie Maleinsäure, Itaconsäure, Mesaconsäure, Crotonsäure, Acrylsäure oder deren Estern, gepfropft werden.

Die erhaltenen Pfropfpolymerisate lassen sich durch Hydrolyse, Alkoholyse oder Umesterung in teil- oder vollverseifte Produkte überführen, wobei der Hydrolysegrad mindestens 1 mol-%, vorzugsweise 70 bis 99 mol-%, bezogen auf die Molzahl verseifbarer Monomereinheiten im Pfropfpolymerisat, beträgt. Die Herstellung der Pfropfpolymerisate mit Polyurethan-Pfropfgrundlage ist in der deutschen Patentanmeldung P 37 32 089 beschrieben.

Die erfindungsgemäßen lichtempfindlichen Gemische enthalten im allgemeinen 20 - 95, vorzugsweise 30 - 70 Gew.-% Bindemittel. Sie enthalten weiterhin mindestens eine radikalisch polymerisierbare olefinisch ungesättigte Verbindung sowie mindestens einen Photoinitiator.

Geeignete Monomere mit einer oder mehreren polymerisierbaren olefinischen Doppelbindungen sind insbesondere Ester und Amide von Acryl- und Methacrylsäure. Beispiele sind die verträglichen Mono- und Diacrylate und -methacrylate von ein- oder mehrwertigen Alkoholen wie Ethylenglykol, Di-, Tri-, Tetra- oder Polyethylenglykolen, letztere bevorzugt mit 10 bis 15 Ethylenglykoleinheiten, 1,3-Propandiol, Glycerin, 1,1,1-Trimethylolpropan, 1,2,4-Butantriol oder Pentaerythrit, z. B. Ethylenglykol-monomethacrylat, 1,3-Propandiolmonomethacrylat, Glycerinmono- und -diacrylat, 1,2,4-Butantriolmonomethacrylat, Pentaerythrittriacrylat, Polyethylenglykolmethyletheracrylat, Tetradecaethylenglykol-dimethacrylat oder der Triether aus Glycerin und 3 mol N-Methylolacrylamid oder -methacrylamid. Die Menge an Monomeren liegt im allgemeinen bei etwa 5 bis 70, bevorzugt bei etwa 10 bis 50 Gew.-% der nichtflüchtigen Betandteile des Gemischs.

Als Photoinitiatoren für die erfindungsgemäßen Gemische kommen die bekannten Verbindungen in Frage, die eine hinreichende thermische Stabilität bei der Verarbeitung der Aufzeichnungsmaterialien sowie eine hinreichende Radikalbildung bei Belichtung unter Initiierung der Polymerisation der Monomeren aufweisen. Sie sollen Licht im Wellenlängenbereich von ca. 250 bis ca. 500 nm unter Bildung von Radikalen absorbieren. Beispiele geeigneter Photoinitiatoren sind Acyloine und deren Derivate wie Benzoin, Benzoinalkylether, z. B. Benzoinisopropylether, vicinale Diketone und deren Derivate, z. B. Benzil, Benzilacetale wie Benzildimethylketal, Fluorenone, Thioxanthone, Mehrkernchinone, Acridine und Chinoxaline; ferner Trichlormethyl-s-triazine, 2-Halogenmethyl-4-styryl-1,3,4-oxadiazolderivate, mit Trichlormethylgruppen substituierte Halogenoxazole, Trihalogenmethylgruppen enthaltende Carbonylmethylenheterocyclen gemäß DE-A 33 33 450, Acylphosphinoxidverbindungen, wie sie z. B. in der DE-A 31 33 419 beschrieben sind, und andere phosphorhaltige Photoinitiatoren, z. B. die in der älteren deutschen Patentanmeldung P 37 28 168 beschriebenen 6-Acyl-(6H)-dibenz[c,e][1,2]-oxaphosphorin-6-oxide, insbesondere das 6-(2,4,6-Trimethylbenzoyl)-(6H)-dibenz-[c,e][1,2]-oxaphosphorin-6-oxid. Die Photoinitiatoren lassen sich auch in Kombination miteinander oder mit Coinitiatoren bzw. Aktivatoren verwenden, z. B. mit Michlers Keton und seinen Derivaten oder 2-Alkyl-anthrachinonen. Die Menge an Photoinitiator beträgt im allgemeinen etwa 0,01 bis 10, bevorzugt etwa 0,5 bis 5 Gew.-% des Aufzeichnungsmaterials.

Oft ist es von Vorteil, dem Aufzeichnungsmaterial noch weitere Hilfs- und Zusatzstoffe zuzugeben, z. B. Inhibitoren der thermischen Polymerisation wie Hydrochinon und seine Derivate, 2,6-Ditert.-butyl-p-kresol, Nitrophenole, Nitrosamine wie N-Nitrosodiphenylamin oder Salze des N-Nitrosocyclohexylhydroxylamins, z. B. dessen Alkali- oder Aluminiumsalze. Weitere übliche Zusätze sind Farbstoffe, Pigmente, Verarbeitungshilfsmittel und Weichmacher.

Die erfindungsgemäßen Gemische lassen sich für die Herstellung von Relief- und Flexodruckplatten durch Gießen aus Lösung oder Extrudieren und Kalandrieren zu Schichten einer Dicke von 0,02 bis 6, vorzugsweise von 0,2 bis 2 mm, ausformen. Die Schicht kann auf die Oberfläche eines geeigneten Trägers laminiert oder eine Lösung der erfindungsgemäßen Gemische kann auf einen Schichtträger aufgebracht werden.

Außer für die Herstellung von Reliefdruckplatten können die erfindungsgemäßen Gemische auch z. B. zur Herstellung von Flachdruckplatten, Tiefdruckzylindern, Siebdruckschablonen und Photoresists verwendet werden.

Geeignete Träger sind je nach Verwendungszweck z. B. Polyesterfolien, Stahl- oder Aluminiumbleche, Kupferzylinder, Siebdruckschablonenträger, Schaumstofflagen, gummielastische Träger oder Leiterplatten. Es kann auch vorteilhaft sein, auf die lichtempfindliche Aufzeichnungsschicht eine Deckbzw. Schutzschicht, z. B. eine dünne Schicht aus Polyvinylalkohol, oder eine abziehbare Deckfolie, z. B. aus Polyethylenglykolterephthalat, aufzubringen. Weiterhin kann eine Vorbeschichtung des Trägers vorteilhaft sein. Die zusätzliche Schicht zwischen dem Träger und der lichtempfindlichen Schicht kann z. B. als Lichthofschutzschicht oder als Haftschicht wirksam sein.

Die erfindungsgemäßen Aufzeichnungsmaterialien können bildmäßig mit aktinischem Licht aus Lichtquellen wie Quecksilberdampflampen oder Leuchtstoffröhren belichtet werden, wobei die emittierte Wellenlänge bevorzugt zwischen 300 und 420 nm liegt. Das Entfernen der unbelichteten und unvernetzten Schichtanteile kann durch Sprühen, Waschen oder Bürsten mit Wasser oder wäßrigen Lösungen, z. B. von Netz- oder Emulgiermitteln, erfolgen. Der Lösung können ferner kleine Mengen Entschäumer oder mit Wasser mischbare organische Lösemittel, z. B. niedere aliphatische Alkohole, zugesetzt werden. Der Mengenanteil an organischen Lösemitteln ist im allgemeinen kleiner als 10 %, bevorzugt kleiner als 5 %. Zweckmäßig werden die entwickelten Reliefformen bei Temperaturen bis 120 °C getrocknet und gegebenenfalls gleichzeitig oder danach mit aktinischem Licht nachbelichtet.

Die erfindungsgemäßen Aufzeichnungsmaterialien eignen sich besonders zur Herstellung von Druckformen, vor allem Hoch- oder Reliefdruckformen, die besonders für den Flexodruck geeignet sind.

Die Erfindung wird durch die nachstehenden Beispiele erläutert. Die Grenzviskositätszahlen $J_0$ in ml/g wurden bei 25 °C im Ostwaldviskosimeter ermittelt. Die Hydrolysegrade (in mol-%) beziehen sich auf die hydrolysierbaren Monomereinheiten im unverseiften Pfropfpolymerisat.

Herstellung von Pfropfpolymerisaten

Herstellungsbeispiel 1

Synthese der Polyurethan-Pfropfgrundlage:

3000 g Polyethylenglykol 600 und 193.1 g 1,4-Butandiol werden gemeinsam mit 1,5 ml 1,4-Dimethylpiperazin auf 75 °C erwärmt und innerhalb von 6 Stunden mit 1428,2 g Isophorondiisocyanat versetzt. Anschließend läßt man zwei Stunden bei 80 °C nachreagieren. $J_0$ des so hergestellten Polyurethans beträgt 10,6 ml/g in Methanol.

Synthese des Pfropfpolymerisats:

1500 g der Polyurethan-Pfropfgrundlage werden auf 80 °C erwärmt und unter Rühren mit einem Gemisch von 3480 g Vinylacetat und 26,1 g Dibenzoylperoxid (75 %ig) innerhalb von 5 Stunden versetzt. Nach einer Nachreaktionszeit von 45 Minuten bei 80 °C wird nicht umgesetztes Vinylacetat durch azeotrope Destillation mit Methanol entfernt. $J_0$ des so hergestellten Pfropfpolymerisats beträgt 17,5 ml/g in THF.

Verseifung des Pfropfpolymerisats:

3476,7 g einer 50 %igen methanolischen Lösung des Pfropfpolymerisats wird bei Raumtemperatur mit 117,3 g 10 %iger methanolischer NaOH versetzt. Die Mischung geliert nach einiger Zeit und wird granuliert. Nach zwei Stunden schlämmt man das erhaltene Granulat in Methanol auf und setzt eine zur NaOH äquivalente Menge an Essigsäure zu. Das Produkt wird abfiltriert, mehrmals mit Methanol gewaschen und getrocknet: $J_o$ beträgt 11,8 ml/g in Wasser, der Hydrolysegrad 91,1 %.

## Herstellungsbeispiel 2

Die Herstellung erfolgt wie bei Beispiel 1, nur werden bei der Verseifung noch 117,3 g Wasser zugesetzt. $J_o$ des so erhaltenen Produkts beträgt 15,1 ml/g in Wasser, der Hydrolysegrad 97,8 %.

## Herstellungsbeispiel 3

Die Herstellung erfolgt wie im Herstellungsbeispiel 1, nur werden bei der Verseifung von 9178 g einer 50 %igen methanolischen Lösung des Pfropfpolymerisats bei Raumtemperatur, 172,1 g 10 %ige methanolische NaOH und 172,1 g Wasser zugesetzt. $J_o$ beträgt 10,1 ml/g in Wasser, der Hydrolysegrad 85,8 %.

## Anwendungsbeispiel 1

57,8 Gt des gemäß Herstellungsbeispiel 1 hergestellten Pfropfpolymerisats, 35,8 Gt Diethylenglykolmonoacrylat, 4,0 Gt Trimethylolpropantriacrylat, 2,0 Gt Benzildimethylketal und 0,8 Gt 2,6-Di-tert.butyl-4-methylphenol werden in einem Kneter bei 155 °C zu einer transparenten Schmelze homogenisiert und anschließend in einer Plattenpresse zwischen einer 0,125 mm dicken Polyesterfolie und einem 0,3 mm dicken anodisch oxydierten Aluminiumblech, das mit einer Polyurethanhaftschicht versehen ist, bei 155 °C zwei Minuten zu einer 0,8 mm dicken Schicht heißgepreßt. Nach Abziehen der Polyesterfolie wird fünf Minuten bildmäßig mit einem UVA-Flachbelichter belichtet und drei Minuten mit Wasser von 40 °C entwickelt. Nach dem Trocknen erhält man eine Reliefdruckplatte mit einer Shore-A-Härte von 91.

## Anwendungsbeispiel 2

145 Gt eines gemäß Herstellungsbeispiel 2 hergestellten Pfropfpolymerisats, 90 Gt 2-Hydroxyethylmethacrylat, 10 Gt Trimethylolpropantriacrylat, 5 Gt Benzildimethylketal und 2 Gt 2,6-Di-tert.butyl-4-methylphenol werden analog zum Anwendungsbeispiel 1 bei 180 °C homogenisiert und zu einer Reliefdruckplatte mit einer Shore-A-Härte von 92 verarbeitet.

## Anwendungsbeispiel 3

In einem gegenläufigen Zweischneckenextruder mit 6 Heizzonen (Schneckendurchmesser D = 34 mm, Schneckenlänge 23 D) wird bei einer Drehzahl von 90 U/min mit 3 kg/h das im Herstellungsbeispiel 2 beschriebene Pfropfpolymerisat eindosiert und bis zur zweiten Heizzone bei 180 °C aufgeschmolzen. Anschließend wird mit 2,2 kg/h eine Lösung, bestehend aus 85 % 2-Hydroxyethylmethacrylat, 9,4 % Trimethylolpropantriacrylat, 4,7 % Benzildimethylketal und 0,9 % 2,6-Di-tert.butyl-4-methylphenol mit einer Kolbenpumpe zugemischt und das Ganze bei 170 °C bis zur sechsten Heizzone homogenisiert. Die Schmelze wird über eine Breitschlitzdüse auf 0,3 mm dickes anodisch oxydiertes Aluminiumblech, das mit einer Polyurethanhaftschicht versehen ist, aufgetragen. Nach Abdecken der flächenförmig vorgeformten Photopolymermasse mit einer 0,125 mm dicken Polyesterfolie wird das Mehrschichtenelement bei 180 °C heißgepreßt, so daß die Dicke der lichtempfindlichen Schicht 1 mm beträgt. Nach Abziehen der Polyesterfolie wird 5 Minuten bildmäßig mit einem UVA-Flachbelichter belichtet und 3 Minuten mit Wasser von 40 °C entwickelt. Nach dem Trocknen erhält man eine Reliefdruckplatte mit einer Shore-A-Härte von 91.

## Anwendungsbeispiel 4

In den im Anwendungsbeispiel 3 beschriebenen Zweischneckenextruder wird das im Herstellungsbeispiel 3 beschriebene Pfropfpolymerisat eindosiert und bis zum Ende der zweiten Heizzone bei 150 °C aufgeschmolzen. Anschließend wird mit 2,2 kg/h eine Lösung, bestehend aus 85 % Diethylenglykolmonomethacrylat, 9,4 % Trimethylolpropantriacrylat, 4,7 % Benzildimethylketal und 0,9 % 2,6-Di-tert.butyl-4-methylphenol mit einer Kolbenpumpe zugemischt und die Mischung bei 130 °C bis zur sechsten Heizzone homogenisiert. Die Schmelze wird über eine Breitschlitzdüse auf 0,3 mm dickes anodisch oxydiertes Aluminiumblech, das mit einer Polyurethanhaftschicht versehen ist, aufgetragen. Nach Abdeckung der flächenförmig vorgeformten Photopolymermasse mit einer 0,125 mm dicken Polyesterfolie wird das Mehrschichtenelement bei 120 °C heißgepreßt, so daß die Dicke der lichtempfindlichen Schicht 1 mm beträgt. Nach Abziehen der Polyesterfolie wird 5 Minuten bildmäßig mit einem UVA-Flachbelichter belichtet und 3 Minuten mit Wasser, das eine Temperatur von 40 °C hat, entwickelt. Nach dem Trocknen erhält man eine Reliefdruckplatte mit einer Shore-A-Härte von 74.

Anwendungsbeispiel 5

Aus

1,0 Gt des in Herstellungsbeispiel 1 beschriebenen Pfropfpolymerisats,

1,0 Gt eines Umsetzungsprodukts aus 1 mol 2,4,4-Trimethylhexamethylen-diisocyanat und 2 mol Hydroxyethylmethacrylat,

0,02 Gt 2,4-Bis-trichlormethyl-6-(4-Styryl-phenyl)-s-triazin,

0,02 Gt eines Azofarbstoffs aus 2,4-Dinitro-6-chlorbenzol-diazoniumsalz und 2-Methoxy-5-acetylamino-N-cyanoethyl-N-hydroxyethylanilin in 50,0 Gt Ethylenglykolmonomethylether und 2,0 Gt Wasser

wird eine Beschichtungslösung hergestellt und auf eine 0,3 mm starke, in Salpetersäure elektrochemisch aufgerauhte, in Schwefelsäure anodisierte und mit einer 0,1-%igen wäßrigen Lösung von Polyvinylphosphonsäure nachbehandelte Aluminiumfolie derart aufgebracht, daß ein Trockenschichtgewicht von 1,1 g/m² erhalten wird.

Die Platte wird danach mit einer 3,5%igen wäßrigen Lösung von Polyvinylalkohol (12 % Restacetylgruppen, K-Wert 4) beschichtet. Nach dem Trocknen wird eine Deckschicht mit einem Gewicht von 0,8 g/m² erhalten. Die erhaltene Druckplatte wird mittels einer 5-kW-Metallhalogenidlampe im Abstand von 110 cm während 100 Sekunden unter einem 13-stufigen Belichtungskeil mit Dichteinkrementen von 0,15 belichtet, auf den zusätzlich ein Silberfilm mit gleichmäßiger Schwärzung ( Dichte 1,57) und gleichmäßiger Absorption über den wirksamen Spektralbereich als Graufilter montiert wird.

Nach der Belichtung wird die Platte mit einem Entwickler folgender Zusammensetzung entwickelt:

5,0 Gt Natriumoctylsulfat,

1,5 Gt Natriummetasilikat x 5H₂O,

1,0 Gt Trinatriumhydrogensulfat x 12H₂O in 92,0 Gt dest. Wasser.

Die nichtbelichteten Schichtbereiche werden innerhalb kurzer Zeit nach der Benetzung durch die Entwicklerflüssigkeit entfernt. Anschließend wird mit Wasser gespült und getrocknet. In der Kopie ist die Stufe 3 voll abgebildet. Auch feinste Raster und Linien der Vorlage werden klar wiedergegeben.

**Ansprüche**

1. Lichthärtbares elastomeres Gemisch, das als wesentliche Bestandteile

a) ein elastomeres Bindemittel,

b) eine radikalisch polymerisierbare, mit dem Bindemittel verträgliche Verbindung mit mindestens einer endständigen ethylenisch ungesättigten Gruppe und einem Siedepunkt bei Normaldruck oberhalb 100 ˚ C und

c) eine Verbindung oder eine Verbindungskombination enthält, die unter Einwirkung von aktinischem Licht die Polymerisation der Verbindung (b) einzuleiten vermag, dadurch gekennzeichnet, daß das Bindemittel ein in Wasser oder einer wäßrigen Lösung lösliches oder dispergierbares Pfropfpolymerisat ist, dessen Pfropfgrundlage ein Polymeres aus Diolkomponenten und Diisocyanatkomponenten mit mindestens 2 Urethangruppen im Molekül ist, auf die Polymerketten aus Einheiten von Carbonsäurevinylestern mit 3 bis 20 Kohlenstoffatomen und/oder deren Verseifungsprodukten und/oder von weiteren ethylenisch ungesättigten Monomeren oder deren Verseifungsprodukten aufgepfropft sind.

2. Lichthärtbares Gemisch nach Anspruch 1, dadurch gekennzeichnet, daß das Pfropfpolymerisat 10 bis 99 Gew.-% aufgepfropfte Bestandteile enthält.

3. Lichthärtbares Gemisch nach Anspruch 1, dadurch gekennzeichnet, daß das Diisocyanat ein aliphatisches oder cycloaliphatisches Diisocyanat ist.

4. Lichthärtbares Gemisch nach Anspruch 1, dadurch gekennzeichnet, daß das Diol ein Gemisch aus einem Polyetherdiol und einem monomeren Diol ist.

5. Lichthärtbares Gemisch nach Anspruch 4, dadurch gekennzeichnet, daß 0,1 bis 0,7 mol monomeres Diol je mol Polyetherdiol eingesetzt werden.

6. Lichthärtbares Gemisch nach Anspruch 1, dadurch gekennzeichnet, daß das Molverhältnis von Diol- zu Diisocyanatkomponente 1 : 0,9 bis 1 : 0,5 beträgt.

7. Lichthärtbares Gemisch nach Anspruch 1, dadurch gekennzeichnet, daß Einheiten von Vinylestern mit 4 bis 12 Kohlenstoffatomen aufgepfropft werden.

8. Lichthärtbares Gemisch nach Anspruch 1, dadurch gekennzeichnet, daß das Pfropfpolymerisat zu 70 bis 99 mol-%, bezogen auf die Zahl verseifbarer Monomereinheiten, verseift ist.

9. Lichthärtbares Gemisch nach Anspruch 1, dadurch gekennzeichnet, daß die radikalisch polymerisierbare Verbindung ein Acryl- oder Methacrylsäureester eines ein- oder mehrwertigen Alkohols oder ein Acryl- oder Methacrylsäureamid ist.

10. Lichthärtbares Gemisch nach Anspruch 1, dadurch gekennzeichnet, daß es 20 bis 95 Gew.-% Pfropfpolymerisat, 5 bis 70 Gew.-% polymerisierbare Verbindungen und 0,01 bis 10 Gew.-% Photopolymerisationsinitiator enthält.

11. Lichthärtbares Aufzeichnungsmaterial mit einem Schichtträger und einer lichthärtbaren Schicht, dadurch gekennzeichnet, daß die lichthärtbare Schicht aus einem Gemisch gemäß einem der Ansprüche 1 bis 10 besteht.